# EUROPEAN PATENT APPLICATION

(11) **EP 4 016 513 A1**
(43) Date of publication of application: **22.06.2022**
(21) Application number: 20882197.5
(22) Date of filing: 29.09.2020
(51) Int. Cl.: G09G 3/3216, G09G 3/3225

(54) **DISPLAY APPARATUS AND ELECTRONIC DEVICE**

(30) Priority: 31.10.2019 CN 201911049708; 31.10.2019 CN 201921866088 U
(71) Applicant: GUANGDONG OPPO MOBILE TELECOMMUNICATIONS CORP., LTD., Dongguan, Guangdong 523860 (CN)
(72) Inventor: YANG, Xin, Dongguan, Guangdong 523860 (CN)
(74) Representative: Thorniley, Peter
(86) International application number: PCT/CN2020/118915
(87) International publication number: WO 2021/082856

(57) **Abstract**

Provided in the embodiments of the present application are a display apparatus and an electronic device, the display apparatus comprising a first display area and a second display area, the first display area and the second display area having the same pixel physical structure, the first display area having a transmittance greater than that of the second display area, the first display area comprising a plurality of first pixel sets, and each first pixel set comprising a plurality of first pixels connected in parallel. The embodiments of the present application can improve the screen-to-body ratio of the electronic device.

## Description

### CROSS REFERENCE TO RELATED APPLICATIONS

The present application claims priorities to Chinese Patent Application No. 201911049708.5 and Chinese Utility Application No. 201921866088.X, titled "DISPLAY DEVICE AND ELECTRONIC EQUIPMENT", filed on October 31, 2019 with the China National Intellectual Property Administration. The entire disclosures of the above applications are incorporated herein by reference.

### FIELD OF THE INVENTION

The present disclosure relates to the field of electronic technology, and particularly to a display device and an electronic equipment.

### BACKGROUND

With the development of communication technology, electronic equipment such as smart phones is becoming more and more popular. During use of the electronic equipment, the electronic equipment can display images through their display screens. For better display and user experience, sizes of the display screens are getting bigger and bigger. However, when the display screens exceed a certain size, the electronic equipment is difficult to hold. Therefore, it is more and more important to increase screen-to-body ratios of the display screens.

In the related art, a camera is disposed on a back of a display device. The display device is provided with a light transmission channel corresponding to the camera, such as a notch or an opening. The camera is configured to obtain external light signals through the light transmission channel for imaging. The light transmission channel occupies an area of a display surface of the display device.

### SUMMARY

The present disclosure provides a display device and an electronic equipment that can increase a screen-to-body ratio of the electronic equipment.

The present disclosure provides a display device. The display device includes a first display area and a second display area. The first display area has a same pixel physical structure as the second display area. A light transmittance of the first display area is greater than a light transmittance of the second display area. The first display area includes a plurality of first pixel groups. Each of the first pixel groups includes a plurality of first pixels connected in parallel with each other.

The present disclosure further provides an electronic equipment including a display device and a functional device. The display device includes a first display area and a second display area. The first display area has a same pixel physical structure as the second display area. The first display area includes a plurality of first pixel groups. Each of the first pixel groups includes a plurality of first pixels connected in parallel with each other. The functional device is disposed in the electronic equipment. The functional device is configured to transmit an optical signal through the first display area.

### BRIEF DESCRIPTION OF DRAWINGS

In order to more clearly illustrate technical solutions in embodiments of the present disclosure, a brief introduction of accompanying drawings used in description of the embodiments will be given below.
FIG. 1 is a schematic structural diagram of an electronic equipment according to an embodiment of the present disclosure.
FIG. 2 is a schematic structural diagram of a display device in the electronic equipment shown in FIG. 1.
FIG. 3 is a cross-sectional view of the display device shown in FIG. 2 along a line P2-P2.
FIG. 4 is a partial schematic diagram of the display device shown in FIG. 2.
FIG. 5 is another partial schematic diagram of the display device shown in FIG. 2.
FIG. 6 is a schematic diagram of a first arrangement of one first display unit in a first display area of the display device shown in FIG. 2.
FIG. 7 is a schematic diagram of a second arrangement of one first display unit in the first display area of the display device shown in FIG. 2.
FIG. 8 is a schematic diagram of a third arrangement of one first display unit in the first display area of the display device shown in FIG. 2.
FIG. 9 is a schematic diagram of a third arrangement of one first display unit in the first display area of the display device shown in FIG. 2.
FIG. 10 is another schematic structural diagram of the display device according to an embodiment of the present disclosure.
FIG. 11 is a cross-sectional view of the display device shown in FIG. 10 along a line P4-P4.
FIG. 12 is a first partial schematic diagram of the display device shown in FIG. 10.
FIG. 13 is a second partial schematic diagram of the display device shown in FIG. 10.
FIG. 14 is a third partial schematic diagram of the display device shown in FIG. 10.
FIG. 15 is a schematic structural diagram of a cooperation of the display device in the electronic equipment and a camera according to an embodiment of the present disclosure.
FIG. 16 is another schematic structural diagram of the cooperation of the display device in the electronic equipment and the camera according to an embodiment of the present disclosure.

### DETAILED DESCRIPTION OF EMBODIMENTS

The present disclosure provides a display device and an electronic equipment. The electronic equipment may include the display device and a camera. The camera may be disposed under the display device. That is, the camera can collect images through the display device. It is understandable that a conventional display device has a relatively low light transmittance, and an effect of the camera collecting images through the display device is not good. In this regard, in the present disclosure, the display device may be partitioned. For example, a light transmittance of a part of the display device corresponding to the camera is set to be greater than a light transmittance of other portions of the display device, which can improve an effect of the camera collecting images. Technical solutions in embodiments of the present disclosure will be clearly and completely described below in conjunction with accompanying drawings in the embodiments of the present disclosure.

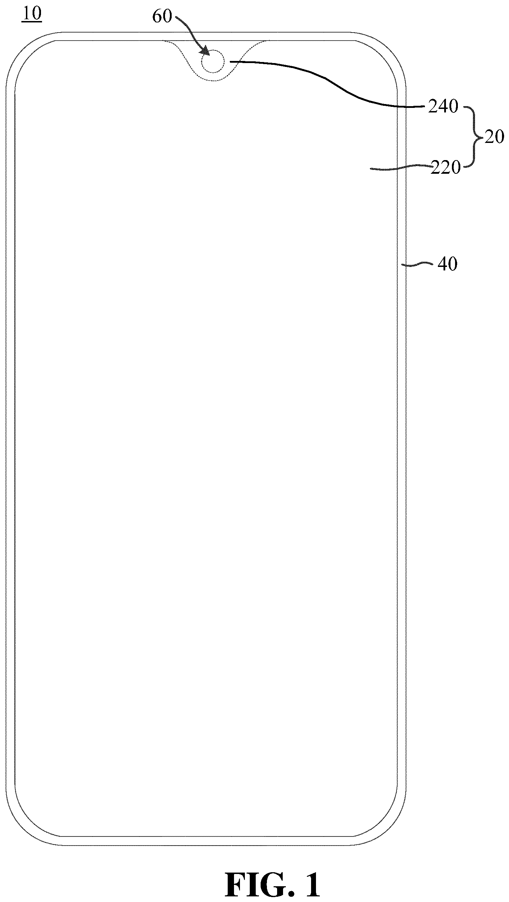

Please refer to FIG. 1. FIG. 1 is a first schematic structural diagram of an electronic equipment according to an embodiment of the present disclosure. The electronic equipment 10 may be a computing device such as a laptop computer, a computer monitor containing an embedded computer, a tablet computer, a cell phone, a media player, or other handheld or portable electronic equipment, a small device (such as a wrist watch device, a hanging device, an earphone or earpiece device, a device embedded in glasses, a device worn on a user's head, or other wearable or miniature devices), a television, a computer monitor avoid of an embedded computer, a game device, a navigation device, an embedded system (such as a system in which an electronic equipment with a display device is installed in a kiosk or a car), a device that implements functions of two or more of the above devices, or other electronic equipment. In an exemplary configuration of FIG. 1, the electronic equipment 10 is a portable device, such as a cell phone, a media player, a tablet computer, or other portable computing device. Other configurations are available to the electronic equipment 10, if desired. FIG. 1 is only exemplary.

It should be understood that a term "a plurality of' mentioned herein means "two or more".

Please refer to FIG. 1, the electronic equipment 10 includes a display device 20. The display device 20 can display images. The display device 20 may be an organic light-emitting diode (OLED) display device 20. A display surface of the display device 20 may have a larger display area and a narrower non-display area. In other words, the display device 20 has a narrower black border. The display surface of the display device 20 may also be a display area, and no non-display area is provided. That is, the display device 20 may have a full screen. A display device cover layer, such as a transparent glass layer, light-transmitting plastic, sapphire, or other transparent dielectric layer, may be used to protect the display device 20.

The display device 20 may have a regular shape, such as a rectangle, a rounded rectangle, or a circle shape. In some other possible embodiments, the display device 20 may have an irregular shape, which is not limited in this embodiment.

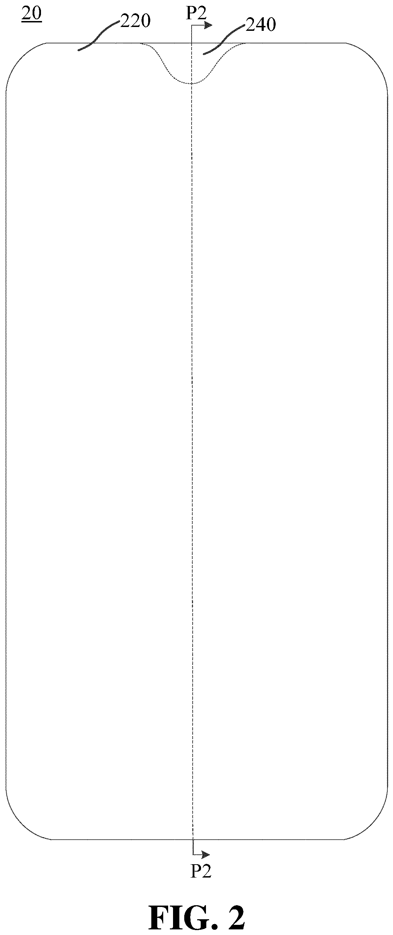

Please refer to FIG. 2. FIG. 2 is a schematic structural diagram of the display device in the electronic equipment shown in FIG. 1. The display device 20 may include a first display area 240 and a second display area 220. Both the first display area 240 and the second display area 220 can display images. The first display area 240 and the second display area 220 may display a same image or different images.

The first display area 240 and the second display area 220 may be adjacent to each other. For example, a periphery of the first display area 240 is surrounded by the second display area 220. For another example, a part of the first display area 240 is surrounded by the second display area 220, that is, the first display area 240 is located at an end surface or a junction of end surfaces of the display device 20. It can be understood that the junction of the end surfaces of the display device 20 is a position where two end surfaces of the display device 20 are connected to each other, and it may include parts of the two end surfaces connected to each other. It should be noted that there may be one or multiple first display areas 240. When there are multiple first display areas 240, and the multiple first display areas 240 may be located on one same end surface of the display device 20, may be located on multiple end surfaces of the display device 20, or may be located on multiple junctions of the end surfaces of the display device 20. Alternatively, some of the first display areas 240 are located at the junctions of the end surfaces of the display device 20, and some of the first display areas 240 are located at the end surfaces of the display device 20.

In this embodiment, an area of the second display area 220 may be set to be greater than an area of the first display area 240. The second display area 220 may be used as a main display area of the display device 20. The first display area 240 may be used as an auxiliary display area or a function display area of the display device 20. For example, a light transmittance of the first display area 240 may be set to be greater than a light transmittance of the second display area 220, thereby greatly improving the light transmittance of the first display area 240 in a non-display state of the first display area 240. A functional component of the electronic equipment 100, such as a camera 60, a sensor, or other component, may be disposed in the first display area 240 to improve a quality of signal transmission of the camera 60, the sensor, or other component through the first display area 240.

It should be noted that in some embodiments, the area of the first display area 240 and the area of the second display area 220 may be set to be same, or the area of the first display area 240 may be set to be greater than the area of the second display area 220.

In this embodiment, the component such as the camera 60 or the sensor may be disposed at a position corresponding to the first display area 240 (such as under the first display area 240). When the first display area 240 is in the non-display state, the component such as the camera 60 or the sensor can perform signal transmission (such as image collection) through the first display area 240. Furthermore, the first display area 240 can also display images as required, so that an integrity of the display device 20 and an integrity of a display area are realized. This not only realizes a hidden design of the component such as the camera 60 or the sensor, but also increases a screen-to-body ratio of the electronic equipment 10.

It should be noted that the functional component of the electronic equipment 10, such as the camera 60 or the sensor, is not limited to be disposed under the first display area 240, and it may be disposed away from the first display area 240. A light guide rod may be disposed between the functional component, such as the camera 60 or the sensor, and the first display area 240 to realize signal transmission. The light guide rod can transmit light signals emitted by the functional component, such as the camera 60 or the sensor, to the first display area 240 and transmit the light signals to an outside of the electronic equipment 10 through the first display area 240. The light guide rod can also transmit an external light signal passing through the first display area 240 to the functional component such as the camera 60 or the sensor. The light guide rod may have a cylindrical structure or a multi-segment structure. When the light guide rod has a multi-segment structure, it may have at least one light guide surface to realize reflection of the light signals.

In order to set the light transmittance of the first display area 240 to be greater than the light transmittance of the second display area 220, in this embodiment, driving units such as thin film transistors (TFTs) in the display device 20 that drive the first display area 240 may be disposed outside the first display area 240. For example, the driving units are disposed in a driving layer that is disposed in the display device 20 to drive the second display area 220. For another example, the driving units are disposed on a side or a periphery of the display device 20. For yet another example, the driving units are disposed in a non-display area of the display device 20. For still another example, a double-layer driving structure is disposed in the display device 20, and the driving units such as TFTs driving the first display area 240 are disposed in a part of the double-layer driving structure corresponding to the second display area 220 through via holes.

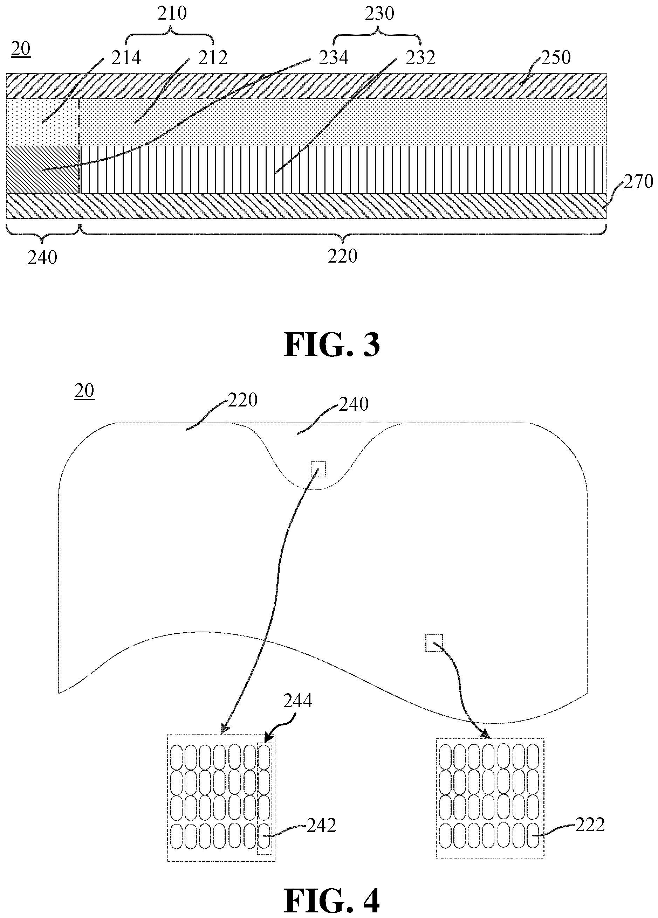

Please refer to FIG. 3. FIG. 3 is a cross-sectional view of the display device shown in FIG. 2 along a line P2-P2. The display device 20 may include an upper substrate 250, a display layer 210, a driving layer 230, and a lower substrate 270 that are sequentially stacked. In the display device 20, the driving layer 230 drives the display layer 210 to display images. Both the upper substrate 250 and the lower substrate 270 may be made of a transparent material, such as transparent glass. The lower substrate 270 may be defined as a first substrate, and the upper substrate 250 may be defined as a second substrate.

The display layer 210 may include multiple pixels. The display layer 210 includes a second display portion 212 located in the second display area 220 and a first display portion 214 located in the first display area 240. That is, the display layer 210 may include a plurality of second pixels disposed in the second display area 220 and a plurality of first pixels disposed in the first display area 240. The second pixels may be disposed in an array, and the first pixels may be disposed in an array. An arrangement of the first pixels 242 in the first display area 240 may be a standard RGB arrangement, a Pentile arrangement, or a Delta arrangement. An arrangement of the second pixels 222 in the second display area 220 may be a standard RGB arrangement, a Pentile arrangement, or a Delta arrangement. It should be noted that the first pixels 242 in the first display area 240 may be arranged in other ways, and the second pixels 222 in the second display area 220 may also be arranged in other ways.

In order to further increase the light transmittance of the first display area 240, the first pixels in the first display area 240 may be made of a light-transmitting material in this embodiment. In some embodiments, the first pixels may be arranged more sparsely than the second pixels. That is, an arrangement density of the first pixels may be less than an arrangement density of the second pixels.

The driving layer 230 may include multiple driving units. Each driving unit can drive one pixel. The driving layer 230 includes a plurality of first driving units for driving the first display area 240 and a plurality of second driving units for driving the second display area 220. Each of the first driving units may be electrically connected to one first pixel and can drive one first pixel. Each of the second driving units may be electrically connected to one second pixel and can drive one second pixel. The driving layer 230 may further include a second driving portion 232 located in the second display area 220 and a first driving portion 234 located in the first display area 240. The second driving units may be disposed in the second driving portion 232, and the first driving units may be disposed in the first driving portion 234.

The driving units may adopt one of 2T1C, 5T1C, 7T1C, and other driving circuits. For example, the first driving units may adopt 2T1C, 5T1C, or 7T1C. The second driving units may adopt 2T1C, 5T1C, or 7T1C. T represents a thin film transistor, and C represents a capacitor. In order to increase the light transmittance of the first display area 240, a driving circuit of each of the first driving units in the first display area 240 may be simpler than a driving circuit of each of the main driving units in the second display area 220. For example, the number of thin film transistors in each of the first driving units is less than the number of thin film transistors in each of the second driving units. For example, the first driving units may adopt 2T1C or 5T1C, and the second driving unit may adopt 7T1C. The fewer the number of opaque thin film transistors in each of the first driving units, the less the opaque parts of the first display area 240. Therefore, the light transmittance of the first display area 240 can be increased.

Please refer to FIG. 4. FIG. 4 is a partial schematic diagram of the display device shown in FIG. 2. A physical structure of the second pixel 242 in the second display area 220 may be same as a physical structure of the first pixel 222 in the first display area 240. In other words, the second display area 220 may have a same pixel physical structure as the first display area 240. For example, a size of the second pixel 222 is same as a size of the first pixel 242, and an arrangement of the second pixels 222 is same as an arrangement of the first pixels 242. The second pixel 222 and the first pixel 242 may be formed in a same process. It should be noted that the physical structure of the second pixel 222 in the second display area 220 may be different from the physical structure of the first pixel 242 in the first display area 240. For example, the size of the second pixel is greater than the size of the first pixel. For another example, the arrangement density of the second pixels is greater than the arrangement density of the first pixels. It should be noted that FIG. 4 only shows some pixels of the display device 20. In FIG. 4, a size of a region formed by the arranged first pixels 242 is substantially same as a size of a region formed by the arranged second pixels 222.

The first display area 240 may have a plurality of first pixel groups 244. Each of the first pixel groups 244 may include a plurality of the first pixels 242 connected in parallel. One first pixel group 244 may include at least two first pixels 242, which may include at least two first pixels 242 of a same color, for example, red pixels. One first pixel group 244 may also include at least two first pixels 242 of different colors, for example, red pixels and green pixels. The plurality of first pixels 242 in one first pixel group 244 may be connected together by a plurality of signal lines. The signal lines may be made of a light-transmitting material.

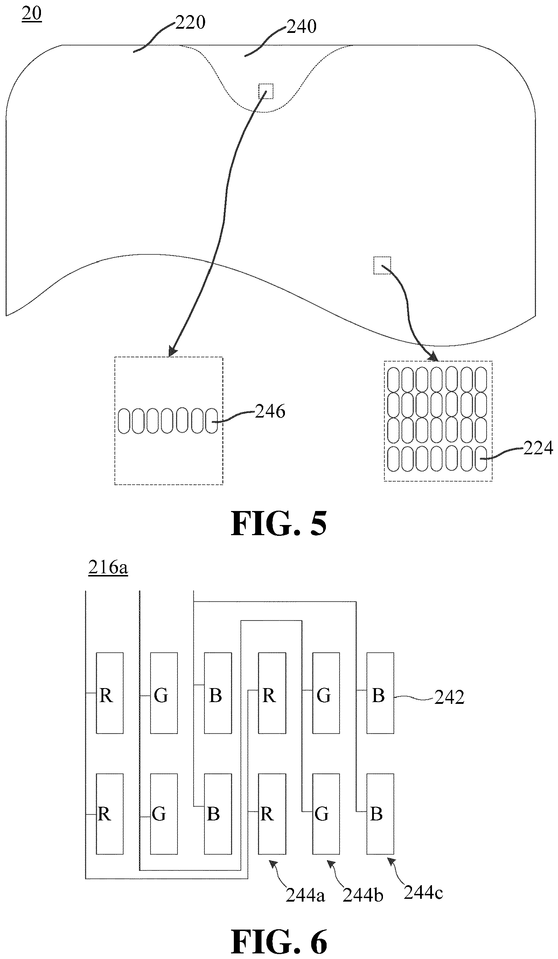

Please refer to FIG. 5. FIG. 5 is another partial schematic diagram of the display device shown in FIG. 2. FIG. 5 shows a plurality of second driving units 224 in the second display area 220 and a plurality of first driving units 246 in the first display area 240. Each of the second driving units 224 may be electrically connected to one second pixel 222. Each of the second driving units 224 may drive one second pixel 222. Each of the first pixel group 244 may be electrically connected to one first driving unit 246. Each of the first driving units 246 may drive one first pixel group 244. That is, each of the first driving units 246 may drive all the first pixels 242 in one first pixel group 244. Compared with one driving unit driving one pixel, the number of first driving units can be reduced in this embodiment. In this embodiment, the first driving units 246 may be disposed in the first display area 240, for example, in the first driving portion 234. Because fewer first driving units 246 are required to drive the first pixels 242 in the first display area 240, the light transmittance of the first display area 240 is improved. It should be noted that FIG. 5 only shows some of the second driving units 224 and some of the first driving units 246 in the display device 20. In FIG. 5, a size of a region formed by the arranged first driving units 246 is substantially same as a size of a region formed by the arranged second driving units 224.

In this embodiment, each of the first pixel groups 244 may be used as one first display unit in the first display area 240, that is, a smallest unit for displaying images in the first display area 240. For example, each of the first pixel groups 244 as one first display unit includes four first pixels 242 of a same color, or sixteen first pixels 242 of a same color. For another example, each of the first pixel groups 244 as one first display unit includes multiple first pixels 242 with different colors. The plurality of second pixels 222 in the second display area 220 may form one second display unit, or a second pixel unit. For example, the second pixel unit in the second display area 220 includes one red pixel, one green pixel, and one blue pixel. Of course, the second pixel unit in the second display area 220 may further include other pixels, such as one white pixel or one yellow pixel.

In this embodiment, multiple first pixel groups 244 may be used as one first display unit. For example, three first pixel groups 244 may be used as one first display unit. For another example, four first pixel groups 244 may be used as one transparent display unit. Each of the first pixel groups 244 in one first display unit may include four first pixels 242 of the same color or sixteen first pixels 242 of the same color. For example, one first display unit includes three first pixel groups 244. Among the three first pixel groups 244, one first pixel group 244 includes four red pixels, another first pixel group 244 includes four green pixels, and the third first pixel group 244 includes four blue pixels.

Please refer to FIG. 6. FIG. 6 is a schematic diagram of a first arrangement of one first display unit in a first display area of the display device shown in FIG. 2. One first display unit 216a in the first display area 240 may include three first pixel groups 244, which may be a first pixel group 244a, a first pixel group 244b, and a first pixel group 244c. The first pixel group 244a may include four red pixels 242 (R). The first pixel group 244b may include four green pixels 242 (G). The first pixel group 244c may include four blue pixels 242 (B). It should be noted that an arrangement of multiple first pixel groups in one first display unit is not limited to this arrangement.

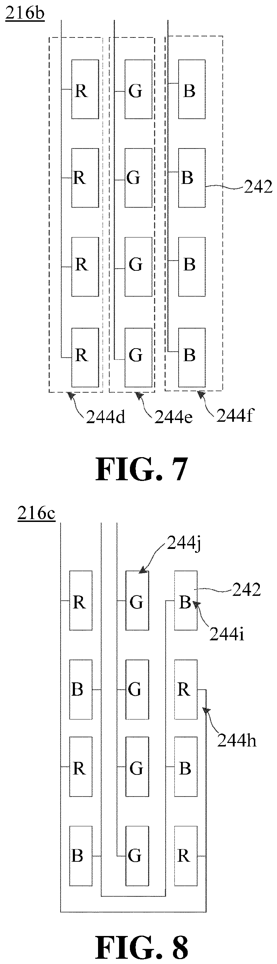

Please refer to FIG. 7. FIG. 7 is a schematic diagram of a second arrangement of one first display unit in the first display area of the display device shown in FIG. 2. One first display unit 216b in the first display area 240 may include three first pixel groups 244, which may be a first pixel group 244d, a first pixel group 244e, and a first pixel group 244f. The first pixel group 244d may include four red pixels 242. The first pixel group 244e may include four green pixels 242. The first pixel group 244f may include four blue pixels 242.

Please refer to FIG. 8. FIG. 8 is a schematic diagram of a third arrangement of one first display unit in the first display area of the display device shown in FIG. 2. One first display unit 216c in the first display area 240 may include three first pixel groups 244, which may be a first pixel group 244h, a first pixel group 244i, and a first pixel group 244j. The first pixel group 244h may include four red pixels 242. The first pixel group 244i may include four green pixels 242. The first pixel group 244j may include four blue pixels 242.

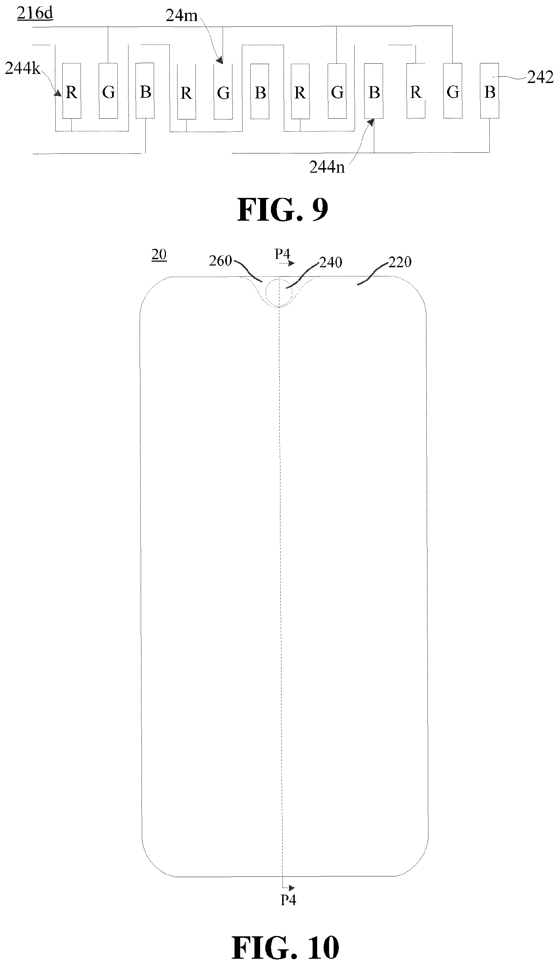

Please refer to FIG. 9. FIG. 9 is a schematic diagram of a fourth arrangement of one first display unit in the first display area of the display device shown in FIG. 2. One first display unit 216d in the first display area 240 may include three first pixel groups 244, which may be a first pixel group 244k, a first pixel group 244m, and a first pixel group 244n. The first pixel group 244k may include four red pixels 242. The first pixel group 244m may include four green pixels 242. The first pixel group 244n may include four blue pixels 242.

It can be understood that when one first display unit in the first display area 240 includes four first pixel groups 244, the first pixels 242 included in each of the four first pixel groups 244 have a same color. For example, one first pixel group 244 includes a plurality of red pixels, a second first pixel group 244 includes a plurality of green pixels, a third first pixel group 244 includes a plurality of blue pixels, and a fourth first pixel group 244 includes a plurality of white pixels. Alternatively, the fourth first pixel group 244 includes a plurality of yellow pixels.

FIG. 6 to FIG. 9 only show some arrangements of one first display unit in the first display area 240 of the display device 20. In this embodiment, one first display unit in the first display area 240 may have other arrangements.

It should be noted that, in some solutions, in order to improve the light transmittance of the first display area, the size of the first pixels in the first display area may be set to be greater than the size of the second pixels in the second display area, and the first pixels in the first display area may be arranged more sparsely than the second pixels in the second display area. Therefore, the first pixels in the first display area and the second pixels in the second display area have different pixel physical structures. In an actual process, because the first pixels in the first display area and the second pixels in the second display area have different pixel physical structures, the pixel structures need to be formed through a series of processes such as exposure, development, and cleaning using different masks. For example, the first pixels in the first display area need to be formed by a first type of mask through a first set of processes. The second pixels in the second display area need to be formed by a second type of mask through a second set of processes. This not only requires additional masks and tools, but also increases processes, increases processing cost and complexity, and reduces a yield of the pixels formed.

In order to save tools and processes, the first pixels in the first display area and the second pixels in the second display area may be formed with a same tool, such as a mask, in a same process, so that the physical structure of each of the first pixels in the first display area is same as the physical structure of each of the second pixels in the second display area. However, when the physical structure of each of the first pixels in the first display area is same as the physical structure of each of the second pixels in the second display area, and the first pixels in the first display area and the second pixels in the second display area are driven in a same way, the first display area needs to be provided with too many wires and the first driving units. Too many wires will affect the light transmittance of the first display area.

In a related solution, in order to reduce processes, process cost, and an arrangement of signal lines in the first display area, to facilitate an arrangement of lines in the first display area, and to improve the light transmittance of the first display area, in this embodiment, at least two pixels in the first display area are connected in parallel to form one first pixel group. Multiple first pixels may be connected to one same signal line after being connected in parallel. Compared with each first pixel being connected to one signal line, the number of the signal lines may be greatly reduced, the arrangement of the signal lines may be facilitated, and the light transmittance of the first display area may be improved.

Accordingly, in this embodiment, at least two first pixels in the first display area are connected in parallel to form one first pixel group, which changes a wiring in a part of the display layer in the first display area without changing a pixel physical structure of the entire display device, so as to greatly reduce the number of the signal lines arranged in the first display area, thereby improving the light transmittance of the first display area.

In order to further improve the light transmittance of the first display area 240, some of all the first driving units for driving the first display area 240 may be disposed in the first display area 240, and others may be disposed in other positions, such as in the second display area 220. For example, some of the first driving units are disposed in the first driving portion 234, and the others are disposed in the second driving portion 232.

In this embodiment, all the first driving units for driving the first display area 240 may be disposed in other positions. For example, all the first driving units may be disposed in the second display area 220.

It should be noted that if the first driving units 246 for driving the first pixels 242 in the first display area 240 are disposed in the second display area 220, such as in the second driving portion 232, wires need to be arranged. Considering that the wires will occupy a space where the first display area 240 and the second display area 220 are connected, if there are too many wires, the space may not be enough to arrange the wires, and it is necessary to increase a thickness to arrange more wires. In order not to increase a thickness of a location where the wires are located, and to ensure that there is enough space for wiring at a connection between the first display area 240 and the second display area 220, at least two first pixels 242 in the first display area 240 may be connected in parallel to form one first pixel group 244 and then connected to one same signal line, which can greatly reduce the number of the signal lines and the space occupied by the signal lines. Therefore, the first driving units 246 for driving the first pixels 242 in the first display area 240 may be disposed in the second display area 220.

However, considering that the second display area 220 is the main display area of the display device 20, if all the first driving units 246 for driving the first display area 240 are disposed in the second display area 220, setting of the second driving portion 232 in the second display area 240 will be affected, and a wiring process of the second driving portion 232 may be affected. This may affect a quality and effect of images displayed in the second display area 220. In this embodiment, in order to reduce an influence of the first driving units 246 on the second display area 220, a third display area may be disposed between the second display area 220 and the first display area 240 to form a transition. The first driving units may be disposed in the third display area to reduce the influence of the first driving units 246 on the second display area 220.

Please refer to FIG. 10. FIG. 10 is another schematic structural diagram of the display device according to an embodiment of the present disclosure. The display device 20 may further include a third display area 260, which may also be referred to as a transition area. The third display area 260 may connect the second display area 220 and the first display area 240. The third display area 260 may be connected between the second display area 220 and the first display area 240. In this embodiment, the third display area 260 may separate the second display area 220 from the first display area 240, so that the second display area 220 and the first display area 240 are not directly connected. In this embodiment, the third display area 260 may connect a part of the second display area 220 and a part of the first display area 240, and other parts of the second display area 220 may be connected to other parts of the first display area 240. A size of the third display area 260 may be much less than a size of the second display area 220. The first display area 240 and the third display area 260 may together form an auxiliary display area of the display device 20. The first display area 240 and the third display area 260 may be defined as auxiliary display areas, or secondary display areas.

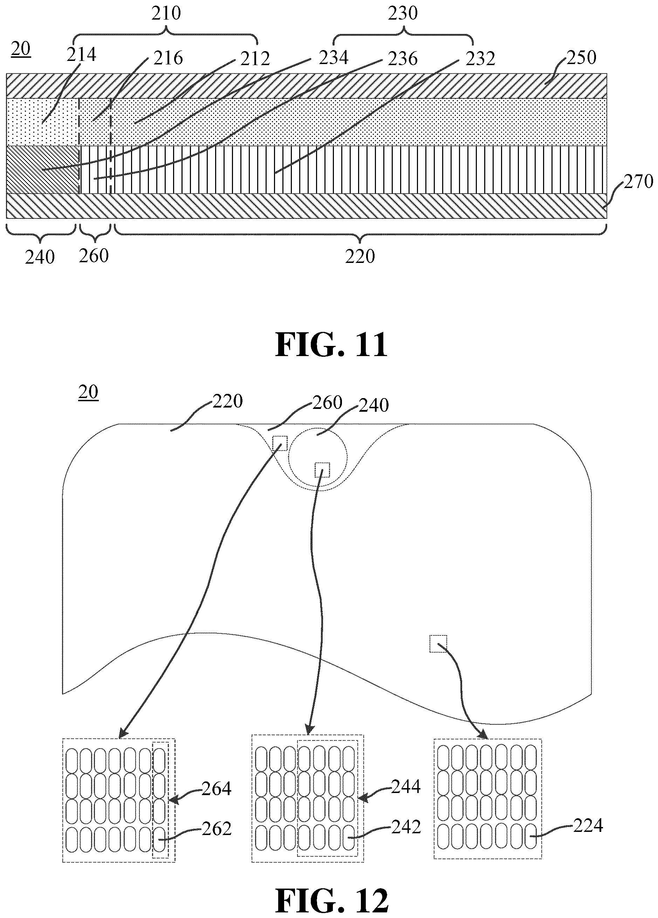

Please refer to FIG. 11. FIG. 11 is a cross-sectional view of the display device shown in FIG. 10 along a line P4-P4. The display layer 210 may further include a third display portion 216 in the third display area 260. The third display portion 216 may be provided with a plurality of third pixels. An arrangement of the third pixels may be a standard RGB arrangement, a Pentile arrangement, or a Delta arrangement. The third pixels may be arranged in other ways. The driving layer 230 may further include a third driving portion 236. The third driving portion 236 may be provided with a plurality of driving units. For example, the third driving portion 236 is provided with a plurality of third driving units, each of the third driving units may be electrically connected to one third pixel, and each of the third driving units may drive one third pixel. The third driving units may adopt 2T1C, 5T1C, or 7T1C. For example, the third drive units adopt 5T1C. In this embodiment, the third display area 260 may adopt 5T1C, the first display area 240 may adopt 2T1C, and the second display area 220 may adopt 7T1C, so that the quality of the images displayed in the second display area 220 is greater than a quality of images displayed in the third display area 260, and the quality of the images displayed in the third display area 260 is greater than a quality of images displayed in the first display area 240. Therefore, a transition is presented between the first display area 240 and the second display area 220.

Driving manners of the first display area 240, the second display area 220, and the third display area 260 are not limited to the above driving manners. For example, the first display area 240 and the third display area 260 both adopt 5T1C, and the second display area 220 adopts 7T1C.

Please refer to FIG. 12. FIG. 12 is a first partial schematic diagram of the display device shown in FIG. 10. An arrangement of the third pixels 262 in the third display area 260 may be same as the arrangement of the second pixels 224 in the second display area 220, and may also be same as the arrangement of the first pixels 242 in the first display area 240. For example, the second display area 220, the third display area 260, and the first display area 240 have a same pixel physical structure. The pixels in the second display area 220, the third display area 260, and the first display area 240 may be formed in a same process. It should be noted that the arrangement of the third pixels 262 in the third display area 260 may be different from the arrangement of the second pixels 224 in the second display area 220 or the arrangement of the first pixels 242 in the first display area 240. It should be noted that FIG. 11 only shows some pixels of the display device 20. In FIG. 11, a size of a region formed by the arranged first pixels 242, a size of a region formed by the arranged third pixels 262, and a size of a region formed by the arranged second pixels 222 are substantially same.

In this embodiment, all the first driving units for driving the first display area 240 may be disposed in the third display area 260. For example, the first driving units are disposed in the third display portion 236, so that a part of the driving layer in the first display area 240 has no first driving units. For example, the first driving portion 234 in the first display area 240 has no thin film transistors. This can greatly improve the light transmittance of the first display area 240. Furthermore, this can avoid other problems caused by disposing the first driving units in the first display area 240, such as diffraction caused by the periodically arranged first driving units to imaging of the camera 60, and stray light caused by reflection and refraction of the first driving units to the imaging of the camera 60.

It should be noted that, as the third display area 260 is provided with a plurality of third driving units, the plurality of third driving units occupy a space of the third driving portion 236. In the present disclosure, the first driving units disposed in the third driving portion 236 also occupy the space of the third driving portion 236, and wires also occupy the space of the third driving portion 236. In order to ensure that the first driving units can be disposed in the third driving portion 236, the wires in the third driving portion 236 may be set thinner, thereby reducing a space occupied by each signal line and accommodating more signal lines.

In this embodiment, the number of third driving units in the third display area 260 may be reduced, so that the first driving units can be disposed in the third driving portion 236 without changing a thickness of the wires in the third driving portion 236, and the wiring requirements can be met.

Please refer to FIG. 12, the third display area 260 may be provided with a plurality of third pixel groups 264. Each of the third pixel groups 264 may include at least two third pixels 262 connected in parallel, and may include at least two third pixels 262 of a same color, such as red pixels. Each of the third pixel groups 264 may include at least two third pixels 262 of different colors, such as red pixels and green pixels. The third pixels 262 in one third pixel group 264 may be connected together by a plurality of signal lines. The number of the third pixels 262 in one third pixel group 264 may be more than the number of the first pixels 242 in one first pixel group 244. For example, one third pixel group 264 includes four third pixels 262, and one first pixel group 244 includes sixteen first pixels 242. In addition, the number of the third pixels 262 in one third pixel group 264 may be same as the number of the first pixels 242 in one first pixel group 244.

In this embodiment, one of the third pixel groups 264 may be used as a third display unit in the third display area 260. For example, a third pixel group 264 as one third display unit includes two third pixels 262 of the same color, or four third pixels 262 of the same color. For another example, a third pixel group 264 as one third display unit includes multiple third pixels 262 with different colors.

In this embodiment, multiple third pixel groups 264 may be used as one third display unit. For example, three third pixel groups 264 may be used as one third display unit. For another example, four third pixel groups 264 may be used as one third display unit. Each of the third pixel groups 264 in one third display unit may include two third pixels 262 of the same color or four third pixels 262 of the same color. For example, one third display unit includes three third pixel groups 264. Among the three third pixel groups 264, one third pixel group 264 includes four red pixels, another third pixel group 264 includes four green pixels, and the third third pixel group 264 includes four blue pixels. Regarding the number of the third pixel groups 264 included in one third display unit and an arrangement of the third pixels 262 in one third display unit, reference may be made to structures of the first display unit shown in FIG. 6 to FIG. 9, which will not be described in detail herein.

It can be understood that when one first display unit in the third display area 260 includes four third pixel groups 264, the third pixels 262 in each of the four third pixel groups 264 have a same color. For example, one third pixel group 264 includes a plurality of red pixels, a second third pixel group 264 includes a plurality of green pixels, a third third pixel group 264 includes a plurality of blue pixels, and a fourth third pixel group 264 includes a plurality of white pixels. Alternatively, the fourth third pixel group 264 includes a plurality of yellow pixels.

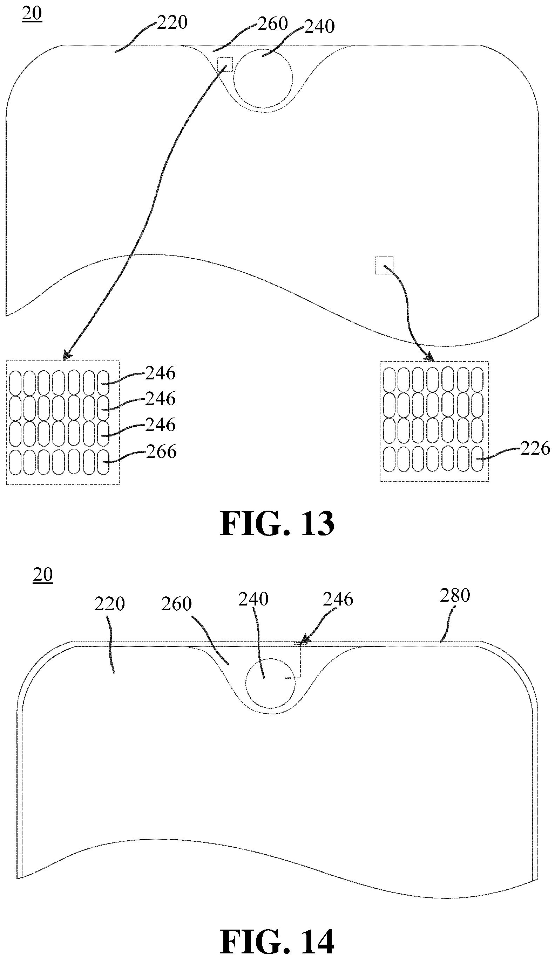

Please refer to FIG. 13. FIG. 13 is a second partial schematic diagram of the display device shown in FIG. 10. FIG. 13 shows a plurality of second driving units 224 in the second display area 220, and a plurality of third driving units 266 and a plurality of first pixel units 246 in the third display area 260. For the second driving units 224, please refer to the above description of FIG. 5, which will not be described in detail herein. The plurality of third driving units 266 and the plurality of second display units 246 are disposed in the third display area 260, for example, in the third driving portion 236.

The plurality of third driving units 266 are configured to drive the third display area 260. Each of the third driving units 266 may be electrically connected to one third pixel group 264. Each of the third driving units 266 may drive one third pixel group 264. That is, each of the third driving units 266 may drive all the third pixels 262 in one third pixel group 264. Compared with one driving unit driving one pixel, this embodiment can reduce the number of the third driving units, thereby reducing a space of the third driving portion 236 occupied by the third driving units, so as to dispose the first driving units 246. For example, each of the third driving units 266 includes four third pixels 262 connected in parallel. One third driving unit 266 may occupy a space corresponding to one third pixel 262, or a space slightly smaller than the space corresponding to the third pixel 262. Therefore, one third pixel group 264 may reserve spaces corresponding to at least three third pixels 262. Multiple first pixel units 264, such as three first driving units 246, may be disposed in the reserved spaces. The three spare third pixels 262 may be in a one-to-one correspondence with the three first driving units 246.

Accordingly, in this embodiment, at least two third pixels 262 in the third display area 260 may be connected in parallel to form one third pixel group 264, multiple third pixels 262 may be driven by one third driving unit 266, so that sufficient space is reserved in the third driving portion 236 for disposing the first driving units 246. Therefore, opaque thin film transistors in the first display area 240 may be disposed in the third display area 260 that does not need to collect light signals through cameras and the like. The size of the third display area 260 may be set smaller, and the third display area 260 connects the first display area 240 and the second display area 220. Therefore, in a case that images displayed in the second display area 220 are not greatly affected, deterioration of a quality of images displayed in the third display area 260 will not have a significant impact on a display effect of the entire display device 20.

In addition, the number of the third pixels 262 connected in parallel in the third display area 260 may be less than the number of the first pixels 242 connected in parallel in the first display area 240, so that a display transition between the first display area 240 and the second display area 220 is smoother.

It should be noted that, in this embodiment, the first driving units are not limited to be disposed in the third display area 260. For example, some of the first driving units are disposed in the third display area 260, and the other first driving units are disposed in the first display area 240. For another example, some of the first driving units are disposed in the third display area 260, and the other first driving units are disposed in the second display area 220. For yet another example, the first driving units are divided into three parts, which are disposed in the first display area 240, the third display area 260, and the second display area 220, respectively.

It should also be noted that, in this embodiment, the first driving units are not limited to be disposed in a display area. The first driving units may be disposed in a side or a non-display area of the display device 20.

Please refer to FIG. 14. FIG. 14 is a third partial schematic diagram of the display device shown in FIG. 10. The display device 20 may further include a non-display area 280. The first driving units 246 for driving the first display area 240 may be disposed in the non-display area 280. The display device 20 may have a full screen. That is, a front surface of the display device 20 is substantially a display area. Viewed from a front surface of the electronic equipment, the front surface of the display device 20 is substantially equal to a display surface of the electronic equipment. However, even if the display device 20 has a full screen, the non-display area 280 still exists at an edge of the display device 20. The non-display area 280 may be understood as a black border of the display device 20. A width of the black border may be very narrow, for example, the width of the black border is less than 1 mm, 0.5 mm, or the like. Because the area of the first display area 240 is small, the number of the first pixels in the first display area 240 is relatively small. Furthermore, multiple first pixels in the first display area 240 may be connected in parallel. Therefore, the number of the first driving units 246 for driving the first display area 240 is reduced. Accordingly, the first driving units 246 may be disposed in the black border, which can improve the light transmittance of the first display area 240 without affecting the second display area 220 or the third display area 260. Multiple first driving units 246 need to be disposed corresponding to the first pixels in the first display area 240, and all the first driving units 246 may be disposed in the black border.

In order to make the black border better accommodate all the first driving units 246, simpler first drive units 246 may be used. For example, the first driving units 246 may adopt 2T1C, 5T1C, or other driving circuit, so that the number of thin film transistors in each of the first driving units 246 is small, and one first driving unit 246 requires less space. An arrangement density of the first pixels in the first display area 240 may be set smaller, so that a total number of the first driving units 246 configured to drive the first display area 240 is smaller. It should be noted that some of the first driving units 246 may be disposed in the non-display area 280 and the other first driving units 246 may be disposed in other position, such as in the first display area 240 or the third display area 260.

It should be noted that, in this embodiment, the way of improving the light transmittance of the first display area 240 is not limited to the above way, and other ways may be used. For example, wires in the first display area 240 of the display device 20 may be set to be transparent, so as to increase the light transmittance of the first display area 24. For another example, the first display area 240 may not be provided with a polarizing structure. For still another example, the driving units for driving the first display area 240 may be driven in a passive way, which can greatly reduce the wires and components in the driving units. It can be understood that solutions of improving the first display area 240 by increasing a light transmittance of a material and changing an arrangement of wires fall within the claimed scope of the present application.

In this embodiment, the second display area 220 may be an active-driven (i.e. active-matrix organic light-emitting diode, AMOLED) display area, and the first display area 240 may be an active-driven display area or a passive-driven (i.e. passive-matrix organic light-emitting diode, PMOLED) display area. In this embodiment, the area of the first display area 240 may be set to be less than the area of the second display area 220, so that a display content of the first display area 240 is less than a display content of the second display area 220, and an importance of the display content of the first display area 240 is lower than an importance of the display content of the second display area 220. Therefore, in this embodiment, using AMOLED in the second display area 220 can ensure that the main display area of the display device 20 have a better display effect. Furthermore, the first display area 240 adopts PMOLED. The passive-driven first display area 240 can be driven by only one thin film transistor, so that the number of opaque thin film transistors is small, which greatly improve the light transmittance of the first display area 240. Moreover, the area of the first display area 240 may be much less than the area of the second display area 220. Even if a quality of images displayed in the first display area 240 is reduced, an entire display of the display device 20 would not be greatly affected. It should be noted that the first display area 240 may be active-driven, so that a display effect of the first display area 240 is close to a display effect of the second display area 220.

In this embodiment, the third display area 260 may be configured as an active-driven display area or a passive-driven display area as required. Because a physical structure of the third pixels 262 in the third display area 260 is same as the physical structure of the first pixel 242 in the first display area 240, the third display area 260 and the first display area 240 may be driven in a same manner. For example, the third display area 260 and the first display area 240 may be passive-driven display areas. If the area of the third display area 260 is larger, or in order to improve a display quality of the third display area 260, the third display area 260 and the second display area 220 may be driven in a same manner, for example, may both be active-driven display areas.

A size and shape of the first pixels 242 in the first display area 240 may be set as required. For example, the first pixel 242 may be shaped as a rectangle or a circle-like shape. Circle-like first pixel 242 may be shaped as a circle, an ellipse, a rounded rectangle, or the like. The circle-like first pixels 242 can address diffraction problem of the first display area 240 because their edges are arc-shaped.

In this embodiment, the functional component of the electronic equipment 10, such as the camera 60 or the sensor, may be disposed inside the display device 20. For example, a lens of the camera 60 faces the lower substrate 270 of the display device 20, and the camera 60 is disposed corresponding to the first display area 240. In other words, the camera 60 is located below the lower substrate 270 in the first display area 240. The camera 60 can acquire external light signals passing through the first display area 240 for imaging. In this embodiment, the lens of the camera 60 and the lower substrate 270 may be spaced apart. Alternatively, the lens of the camera 60 may be a part of the lower substrate 270. For example, a part of the lower substrate 270 corresponding to the first display area 240 is formed into an arc-shaped structure.

In order to reduce a space of the electronic equipment 10 occupied by the camera 60, the lens of the camera 60 may be disposed close to or adjacent to the lower substrate 270 of the display device 20. The lower substrate 270 of the display device 20 is mainly configured to carry other layers of the display device 20 and does not need to have any special function.

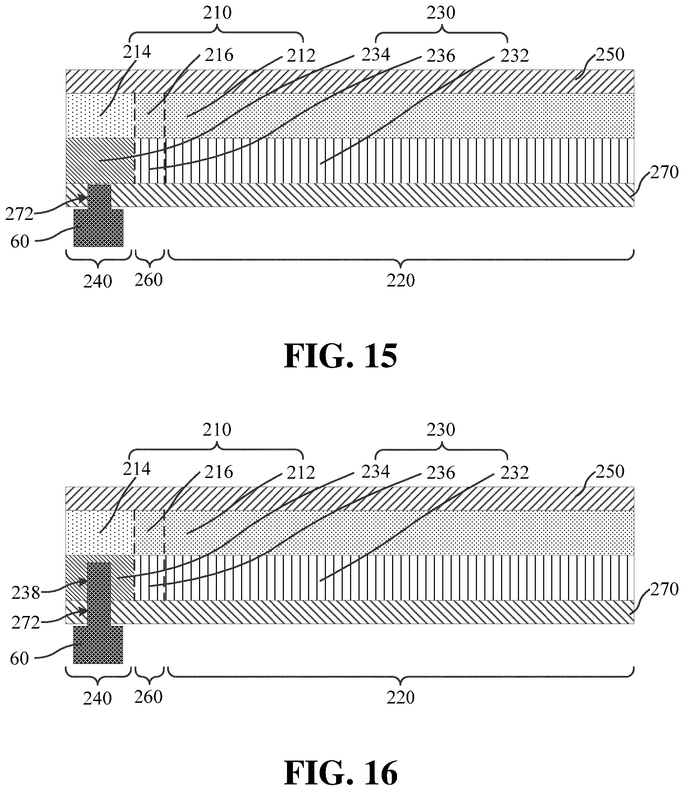

Please refer to FIG. 15. FIG. 15 is a schematic structural diagram of a cooperation of the display device in the electronic equipment and a camera according to an embodiment of the present disclosure. In order to further reduce a space inside the electronic equipment 10 occupied by the camera 60, a part of the lower substrate 270 corresponding to the camera 60 may be provided with a first mounting hole 272. The camera 60 may be disposed at least partially in the first mounting hole 272. The first mounting hole 272 may be a blind hole. That is, a thickness of the part of the lower substrate 270 corresponding to the camera 60 is less than a thickness of other parts. The lower substrate 270 is still a complete substrate, its function of carrying other layers of the display device 20 is not affected, and a part of its space is reserved to accommodate the camera 60. The first mounting hole 272 and the camera 60 may be installed according to a size of the first mounting hole 272 and a size of the camera 60. For example, if a space of the first mounting hole 272 is not enough to install an entirety of the camera 60, the lens of the camera 60 may be disposed in the first mounting hole 272. If the camera is small enough, the entirety of the camera 60 may be disposed in the first mounting hole 272.

It should be noted that the camera may be replaced with another functional device of the electronic equipment 10, such as a sensor. That is, at least a part of the sensor of the electronic equipment 10 may be disposed in the first mounting hole 272.

Please refer to FIG. 16. FIG. 16 is another schematic structural diagram of the cooperation of the display device in the electronic equipment and the camera according to an embodiment of the present disclosure. Because the part of the driving layer 230 in the first display area 240 may not be provided with the first driving units, the camera 60 may be installed in the driving layer. Specifically, the first mounting hole 272 opened in the lower substrate 270 is a through hole. The part of the driving layer 230 in the first display area 240 is provided with a second mounting hole 238 corresponding to the camera 60. The first mounting hole 272 communicates with the second mounting hole 238. The camera 60 may be disposed at least partially in the second mounting hole 238. For example, the lens of the camera 60 is disposed in the first mounting hole 272 and the second mounting hole 238. The second mounting hole 238 may be a through hole or a blind hole. The first mounting hole 272 and the second mounting hole 238 may be formed after some laminate layers of the display device 20 are formed. For example, after the driving layer 230 and the display layer 210 of the display device 20 are disposed on the lower substrate 270, the first mounting hole 272 and the second mounting hole 238 are formed in the parts of the driving layer 230 and the display layer 210 corresponding to the lens of the camera 60 using a laser or the like.

It should be noted that the camera may be replaced with another functional device of the electronic equipment 10, such as a sensor. That is, at least a part of the sensor of the electronic equipment 10 may be disposed in the first mounting hole 272 and the second mounting hole 238.

It can be understood that the camera 60 corresponding to the first display area 240 may be used as a front camera of the electronic equipment. A front camera is generally a camera with a lens that cannot be moved. Because the lower substrate and the driving layer of the display device 20 may be provided with the first mounting hole and the second mounting hole, the camera 60 corresponding to the first display area 240 may be a camera with a movable lens. The lens of the camera 60 can be moved to realize functions such as auto focus. It should be noted that the camera 60 may be a rear camera. That is, the electronic equipment 10 may be provided with two opposite display devices 20.

One camera 60 or multiple cameras 60 may be disposed under the first display area 240. The multiple cameras 60 may be cameras 60 that cooperate with each other, such as two identical cameras, a normal camera, and a bokeh camera or a black-and-white camera. In addition to the camera, other functional devices, such as a proximity sensor, a light sensor, a ranging sensor, a fingerprint recognition sensor, and the like, may be further disposed under the first display area 240.

Please refer to FIG. 1, the electronic equipment 10 may further include a housing 40. The housing 40 may be made of plastic, glass, ceramic, a fiber composite, a metal (e.g. stainless steel and aluminum), other suitable material, or a combination of any two or more of these materials. The housing 40 may be integrally formed. In an integrally formed process, some or all of the housing 40 is machined or molded as a single structure, or may be formed from multiple structures (e.g. an inner frame structure, and one or more structures forming an outer housing surface). The housing 40 may be provided with a receiving cavity to receive components of the electronic equipment 10 such as a battery, a circuit board, and the like. The housing 40 may carry the display device 20.

The display device and the electronic equipment provided by the present disclosure are described in detail above. The present disclosure uses specific examples to describe principles and embodiments of the present application. The above description of the embodiments is only for helping to understand the present application. Furthermore, those skilled in the art may make modifications to the specific embodiments and applications according to ideas of the present application. In conclusion, the present specification should not be construed as a limitation to the present application.

Some exemplary embodiments are given below.
Example 1: A display device, comprising a first display area and a second display area, wherein the first display area has a same pixel physical structure as the second display area, the first display area comprises a plurality of first pixel groups, and each of the first pixel groups comprises a plurality of first pixels connected in parallel with each other.
Example 2: The display device according to Example 1, further comprising a plurality of first driving units, wherein each of the first driving units is electrically connected to one of the first pixel groups and is configured to drive all the first pixels in one of the first pixel groups.
Example 3: The display device according to Example 2, further comprising a plurality of second driving units and a plurality of second pixels, wherein each of the second driving units is electrically connected to one of the second pixels and is configured to drive one of the second pixels, and at least a part of the plurality of first driving units are disposed in the second display area.
Example 4: The display device according to Example 2, further comprising a plurality of second driving units and a plurality of second pixels, wherein each of the second driving units is electrically connected to one of the second pixels and is configured to drive one of the second pixels, and the plurality of first driving units are disposed in the first display area.
Example 5: The display device according to Example 3, wherein each of the first driving units is 5T1C or 2T1C, and each of the second driving units is 7T1C.
Example 6: The display device according to Example 1, wherein the first pixels are passively driven, and the second pixels in the display area are actively driven.
Example 7: The display device according to Example 2, further comprising a third display area connected to the first display area and the second display area, wherein the third display area has a same pixel physical structure as the second display area and the first display area, and the plurality of first driving units are disposed in the third display area.
Example 8: The display device according to Example 7, further comprising a plurality of third driving units disposed in the third display area, wherein each of the third driving units is configured to drive at least one of third pixels in the third display area, and each of the third driving units is disposed corresponding to one of the third pixels.
Example 9: The display device according to Example 8, wherein each of the third driving units is electrically connected to one of the third pixels and is configured to drive one of the third pixels, and each of the third pixels is disposed corresponding to one of the third driving units and is disposed corresponding to at least one of the first driving units.
Example 10: The display device according to Example 8, wherein the third display area comprises a plurality of second pixel groups, each of the second pixel groups comprises multiple third pixels connected in parallel with each other, each of the third driving units is electrically connected to one of the second pixel groups and is configured to drive all the third pixels in one of the second pixel groups, one of the second pixel groups is disposed corresponding to one of the third driving units, and one of the second pixel groups is disposed corresponding to at least one of the first driving units.
Example 11: The display device according to Example 10, wherein each of the second pixel groups comprises four third pixels, and each of the second pixel groups is disposed corresponding to one of the third driving units and three of the first driving units.
Example 12: The display device according to Example 11, further comprising a plurality of display units disposed in the third display area, wherein each of the second pixel groups comprises four third pixels of a same color, and each of the display units disposed in the third display area comprises at least three of the second pixel groups of different colors.
Example 13: The display device according to Example 12, wherein the number of the third pixels in each of the second pixel groups is less than the number of the first pixels in each of the first pixel groups.
Example 14: The display device according to Example 13, wherein each of the first pixel groups comprises sixteen first pixels.
Example 15: The display device according to Example 14, further comprising a plurality of first display units disposed in the first display area, wherein each of the first pixel groups comprises sixteen first pixels of a same color, and each of the display units disposed in the first display area comprises at least three of the first pixel groups of different colors.
Example 16: The display device according to Example 12, wherein the pixels in the first display area, the second display area, and the third display area are formed in a same process.
Example 17: The display device according to Example 2, further comprising a non-display area, wherein the first driving units are disposed in the non-display area.
Example 18: An electronic equipment comprising a display device and a functional device. The display device comprises a first display area and a second display area. The first display area has a same pixel physical structure as the second display area. The first display area comprises a plurality of first pixel groups. Each of the first pixel groups comprises a plurality of first pixels connected in parallel with each other. The functional device is disposed in the electronic equipment. The functional device is configured to transmit an optical signal through the first display area.
Example 19: The electronic equipment according to Example 18, wherein the display device further comprises a first substrate, a driving layer, and a display layer. The first substrate is provided with a first mounting hole corresponding to the first display area. The driving layer is disposed on the first substrate. The display layer is disposed on the driving layer. The first substrate is disposed between the functional device and the display layer. The functional device is at least partially located in the first mounting hole.
Example 20: The electronic equipment according to Example 19, wherein the driving layer is provided with a second mounting hole corresponding to the first display area, the second mounting hole communicates with the first mounting hole, and the functional device is at least partially located in the second mounting hole.

## Claims

1. A display device, comprising a first display area and a second display area, wherein the first display area has a same pixel physical structure as the second display area, the first display area comprises a plurality of first pixel groups, and each of the first pixel groups comprises a plurality of first pixels connected in parallel with each other.

2. The display device as claimed in claim 1, further comprising a plurality of first driving units, wherein each of the first driving units is electrically connected to one of the first pixel groups and is configured to drive all the first pixels in one of the first pixel groups.

3. The display device as claimed in claim 2, further comprising a plurality of second driving units and a plurality of second pixels, wherein each of the second driving units is electrically connected to one of the second pixels and is configured to drive one of the second pixels, and at least a part of the plurality of first driving units are disposed in the second display area.

4. The display device as claimed in claim 2, further comprising a plurality of second driving units and a plurality of second pixels, wherein each of the second driving units is electrically connected to one of the second pixels and is configured to drive one of the second pixels, and the plurality of first driving units are disposed in the first display area.

5. The display device as claimed in claim 3, **characterized in that** each of the first driving units is 5T1C or 2T1C, and each of the second driving units is 7T1C.

6. The display device as claimed in claim 1, **characterized in that** the first pixels are passively driven, and the second pixels in the display area are actively driven.

7. The display device as claimed in claim 2, further comprising a third display area connecting the first display area and the second display area, wherein the third display area has a same pixel physical structure as the second display area and the first display area, and the plurality of first driving units are disposed in the third display area.

8. The display device as claimed in claim 7, further comprising a plurality of third driving units disposed in the third display area, wherein each of the third driving units is configured to drive at least one of third pixels in the third display area, and each of the third driving units is disposed corresponding to one of the third pixels.

9. The display device as claimed in claim 8, **characterized in that** each of the third driving units is electrically connected to one of the third pixels and is configured to drive one of the third pixels, and each of the third pixels is disposed corresponding to one of the third driving units and is disposed corresponding to at least one of the first driving units.

10. The display device as claimed in claim 8, **characterized in that** the third display area comprises a plurality of second pixel groups, each of the second pixel groups comprises a plurality of third pixels connected in parallel with each other, each of the third driving units is electrically connected to one of the second pixel groups and is configured to drive all the third pixels in one of the second pixel groups, one of the second pixel groups is disposed corresponding to one of the third driving units, and one of the second pixel groups is disposed corresponding to at least one of the first driving units.

11. The display device as claimed in claim 10, **characterized in that** each of the second pixel groups comprises four third pixels, and each of the second pixel groups is disposed corresponding to one of the third driving units and three of the first driving units.

12. The display device as claimed in claim 11, further comprising a plurality of display units disposed in the third display area, wherein each of the second pixel groups comprises four third pixels of a same color, and each of the display units disposed in the third display area comprises at least three of the second pixel groups of different colors.

13. The display device as claimed in claim 12, **characterized in that** the number of the third pixels in each of the second pixel groups is less than the number of the first pixels in each of the first pixel groups.

14. The display device as claimed in claim 13, **characterized in that** each of the first pixel groups comprises sixteen first pixels.

15. The display device as claimed in claim 14, further comprising a plurality of first display units disposed in the first display area, wherein each of the first pixel groups comprises sixteen first pixels of a same color, and each of the display units disposed in the first display area comprises at least three of the first pixel groups of different colors.

16. The display device as claimed in claim 12, **characterized in that** the pixels in the first display area, the second display area, and the third display area are formed in a same process.

17. The display device as claimed in claim 2, further comprising a non-display area, wherein the first driving units are disposed in the non-display area.

18. An electronic equipment, comprising:
a display device comprising a first display area and a second display area, wherein the first display area has a same pixel physical structure as the second display area, the first display area comprises a plurality of first pixel groups, and each of the first pixel groups comprises a plurality of first pixels connected in parallel with each other; and
a functional device disposed in the electronic equipment and configured to transmit an optical signal through the first display area.

19. The electronic equipment as claimed in claim 18, **characterized in that** the display device further comprises:
a first substrate provided with a first mounting hole corresponding to the first display area;
a driving layer disposed on the first substrate; and
a display layer disposed on the driving layer;
wherein the first substrate is disposed between the functional device and the display layer, and the functional device is at least partially located in the first mounting hole.

20. The electronic equipment as claimed in claim 19, **characterized in that** the driving layer is provided with a second mounting hole corresponding to the first display area, the second mounting hole communicates with the first mounting hole, and the functional device is at least partially located in the second mounting hole.
